# EUROPÄISCHE PATENTSCHRIFT

(11) **EP 2 119 989 B1**
(45) Veröffentlichungstag und Bekanntmachung des Hinweises auf die Patenterteilung: **01.08.2012**
(21) Anmeldenummer: 09006073.2
(22) Anmeldetag: 04.05.2009
(51) Int. Cl.: F27B 14/20, F27B 17/02, F27D 21/00, H05K 7/14

(54) **Halterung für elektrische Bauelemente mit hoher thermischer Isolationsfähigkeit**
Holder for electrical components with high thermal insulation
Fixation pour composants électriques dotés d'une capacité d'isolation thermique élevée

(30) Priorität: 15.05.2008 DE 102008023683
(43) Veröffentlichungstag der Anmeldung: 18.11.2009
(73) Patentinhaber: Finze & Wagner Ingenieurgesellschaft UDI mbH, 84489 Burghausen (DE)
(72) Erfinder: Wagner, Hans-Peter, Dr., 84489 Burghausen (DE); Geiwagner, Peter, 84375 Kirchdorf/Inn (DE)
(74) Vertreter: Keilitz, Wolfgang

(56) Entgegenhaltungen:
- US-A- 5 378 144
- US-A- 5 734 149
- US-A1- 2004 115 583
- US-B2- 6 619 952

## Beschreibung

Die Erfindung betrifft eine Halterung für Speicherchips mit hoher thermischer Isolationsfähigkeit und Schutzmaßnahmen gegen äußere Einwirkungen gemäß dem Oberbegriff des Patentanspruchs 1.

Metallschmelzen zur Herstellung von Metallteilen werden üblicherweise In Schmelztiegel abgefüllt, die gleichzeitig als Transportbehälter dienen. Aus logistischen Gründen sollen die Transportbehälter mit Speicherchips versehen werden, auf denen beispielsweise Daten über die Füllmenge, Inhalt, Herkunft, Lieferzeit, etc. gespeichert werden können. Da die Schmelztiegel eine Außentemperatur von mehreren 100°C aufweisen können, muss der Chip, wie z.B. ein RFID bzw. Transponder ausreichend thermisch isoliert sein. Bekannte Halterungen sind für die bei der Metallverarbeitung auftretenden hohen Temperaturen und die rauen Umgebungsbedingungen nicht geeignet.

Aus der US 6,619,952 ist eine Halterung für ein Steuergerät zur Montage an einem Bremoten bekannt, wobei die Halterung wenigstens einen Kanal aufweist, durch den Luft strömen kann, um das Steuergerät zu kühlen. Das Steuergerät befindet sich im eingebauten Zustand außen an der Halterung und ist von außen frei zugänglich, um den Ofen bedienen zu können. In dieser Position ist das Steuergerät gegenüber mechanischen Belastungen und Stößen von außen ungeschützt. Darüber hinaus ist die Halterung nur für Umgebungen von bis zu etwa 200°C ausgelegt.

Es ist somit die Aufgabe der vorliegenden Erfindung, eine Halterung für einen Speicherchip mit hoher thermischer Isolierfähigkeit und Witterungsbeständigkeit zu schaffen, die insbesondere den thermischen Anforderungen bei der Metallverarbeitung genügt Die Halterung soll insbesondere geeignet sein, um sie an der Außenwandung eines Schmelztiegels anzubringen und den Speicherchip vor mechanischen und thermischen Belastungen zu schützen.

Gelöst wird diese Aufgabe gemäß der Erfindung durch die im Patentanspruch 1 angegebenen Merkmale. Weitere Ausgestaltungen der Erfindung sind Gegenstand von Unteransprüchen.

Ein wesentlicher Aspekt der Erfindung besteht darin, eine Halterung zu schaffen, die wenigstens einen durchgehenden Kanal umfasst, der zur Kühlung des Speicherchips dient. Die Halterung umfasst feiner eine äußere Abdeckung mit einem Bauraum für den Speicherchip, die den Chip vor mechanischen Belastungen und Stößen schützt und wenigstens einen durchgehenden Kühlkanal umfasst, der im Bauraum mündet. Dadurch wird das elektrische Bauteil vor mechanischen Belastungen geschützt und gleichzeitig noch besser gekühlt.

Ein erfindungsgemäßer Kanal kann beispielsweise zwischen zwei Elementen gebildet sein, die im Abstand zueinander angeordnet sind. Der Kanal wird in diesem Fall durch den Freiraum zwischen den Elementen gebildet. Wahlweise kann der wenigstens eine Kanal auch durch ein Element des Halters hindurch verlaufen, z. B. in Form einer oder mehrerer Durchgangsbohrungen. Eine weitere Alternative umfasst ein Element, das durch sein spezielles, z. B. U-förmiges oder geripptes, Profil einen Kanal bildet. Diese Ausführungsformen können auch kombiniert werden.

Die genannten Elemente sind vorzugsweise plattenförmig gebildet und aus einem thermisch isolierenden Material, wie z. B. PVDF, oder aus Metall hergestellt.

Die erfindungsgemäße Halterung umfasst auch eine Abdeckung für den Speicherchip, die den Chip zumindest nach außen hin abschirmt. Wahlweise kann auch ein Gehäuse vorgesehen sein, das den Chip vollständig umschließt. Die Abdeckung bzw. das Gehäuse umfasst einen oder mehrere durchgehende Kanäle zum Zwecke der Kühlung.

Gemäß einer bevorzugten Ausführungsform der Erfindung umfasst die Halterung ein metallisches Element, wie z. B. eine Blechplatte, das im Abstand zur Oberfläche des Schmelztiegels montiert wird, und wenigstens ein thermisch isolierendes Element, wie z. B. eine Isolierplatte, das im Abstand zum ersten Element angeordnet ist. Zwischen dem Schmelztiegel und der Metallplatte als auch zwischen Metallplatte und isolierendem Element befindet sich somit jeweils ein Kanal, durch den Luft strömen kann. Je nach Ausführungsform können ein oder mehrere weitere Elemente im Abstand übereinander auf dem thermisch isolierenden Element angeordnet sein. Ganz außen befindet sich vorzugsweise den Speicherchip mit einer darüber liegenden Abdeckung oder einem Gehäuse. Die Abdeckung bzw. das Gehäuse ist vorzugsweise ebenfalls im Abstand zu dem drunter liegenden Element angeordnet.

Die Abdeckung ist vorzugsweise aus Kunststoff (z. B. PVDF) hergestellt und hat vorzugsweise auf der Innenseite eine Ausnehmung, die den Transponder aufnimmt. Die Ausnehmung kann z. B. gefräst sein. Die Größe der Ausnehmung entspricht vorzugsweise etwa den Maßen des Transponders und lässt etwas Spiel für Kühlzwecke. Zwischen der Kontur und dem Transponder kann ein Abstandselement, wie z. B. ein Plättchen vorgesehen sein, das einen Spalt zwischen Transponder und Abdeckung offen hält, der wiederum zur Kühlung beiträgt.

Die Abdeckung kann einen oder mehrere durchgehende Kanäle aufweisen, die von einer Stirnseite bis zur gegenüberliegenden Stirnseite des Elements verlaufen. Der bzw. die Kanäle münden vorzugsweise auch in der Ausnehmung und stehen mit dem Bauraum für den Transponder in Verbindung Hierdurch entsteht wiederum ein zusätzlicher Kühleffekt.

Die Erfindung wird nachstehend anhand der beigefügten Zeichnungen näher erläutert.

Es zeigten:
Fig. 1 eine schematische Darstellung der Komponenten einer Halterung für einen Speicherchip; und
Fig. 2a,2b Detailansichten der Abdeckung für den Transponder.

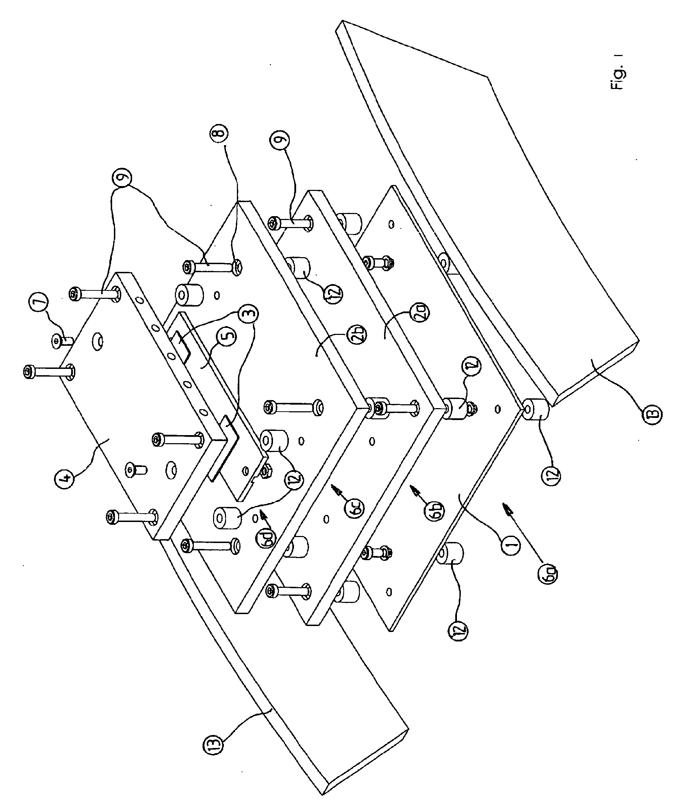

Fig. 1 zeigt eine spezielle Ausführungsform einer Halterung für einen Speicherchip 5, insbesondere einen Transponder. Die Halterung umfasst eine Metallplatte 1 zur Montage auf einem Schmelztiegel. Die Metallplatte 1 ist über Abstandshalter 12 im Abstand zur Oberfläche des Schmelztiegels angeordnet. Zwischen Schmelztiegel und Metallplatte 1 bildet sich somit ein Kanal 6a, der zur Erzeugung eines Kamineffekts dient. Im montierten Zustand strömt Luft durch den Kanal 6a nach oben und kühlt die Halterung und den Speicherchip 5.

Auf der Metallplatte 1 befindet sich eine thermisch isolierende Platte 2a, die vorzugsweise aus einem Kunststoff, wie z. B. PVDF hergestellt ist. Zwischen den beiden Platten 1 und 2a sind Abstandshalter 12 angeordnet, die wiederum einen Kanal 6b frei halten, der zur Kühlung des Bauteils beiträgt.

Je nach Anforderung der Applikation können auf der Platte 2a eine oder mehrere weitere Platten 2b im Abstand angeordnet sein. Im vorliegenden Ausführungsbelsplel ist eine Platte 2b vorgesehen, die ebenfalls aus Kunststoff hergestellt ist. Zwischen den beiden Platten 2a und 2b ist ein Kanal 6c gebildet.

Jedes der Elemente 2a, 2b und 4 hat Bohrungen 8 zur Befestigung des Elements an einem anderen Element. Die Bohrungen 8 sind dabei so angeordnet, dass jedes Element 2a, 2b und 4 mit einem beliebigen anderen mittels Schrauben 9 verschraubt werden kann.

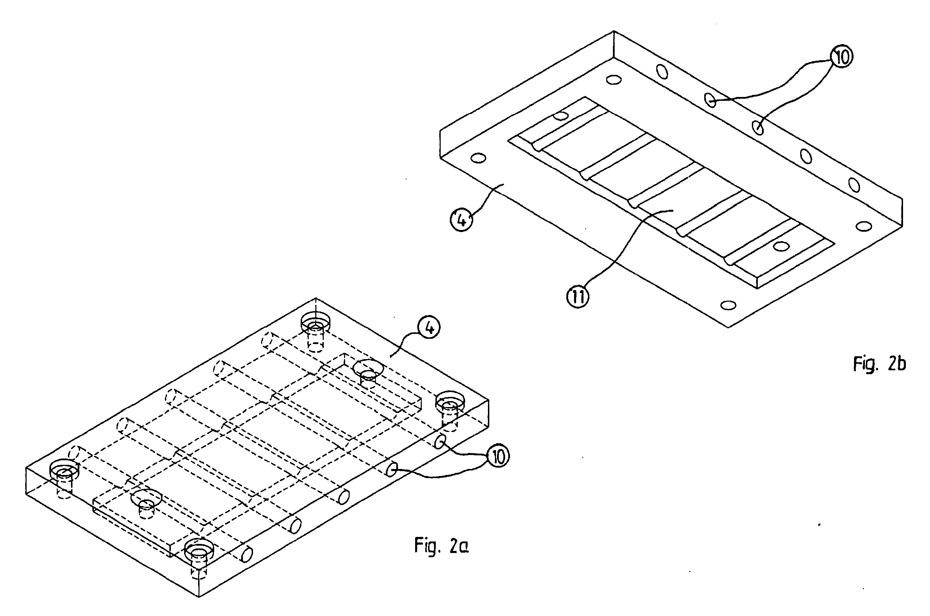

Auf der äußeren Isolierplatte 2b ist eine Abdeckung 4 für den Transponder 5 vorgesehen, die wiederum mittels Abstandshaltern 12 im Abstand zur darunter liegenden Platte 2b gehalten wird. Wie in den Fig. 2a und 2b zu erkennen ist, hat die Abdeckung 4 an ihrer Innenseite eine Ausnehmung 11 zur Aufnahme des Transponders 5. Die Größe der Ausnehmung 11 entspricht dabei in etwa der Größe des Transponders 5. Zwischen der Abdeckung 4 und dem Transponder 5 sind Distanzbleche 3 angeordnet, die einen Spalt frei halten, durch den wiederum Luft zur Kühlung strömen kann. Der Transponder 5 wird mittels Kunststoffschrauben 7 in der Ausnehmung 11 befestigt.

Die Abdeckung 4 hat außerdem mehrere durchgehende Kanäle 10, die von einer Stirnseite bis zur gegenüberliegenden Stirnseite verlaufen. Die Kanäle münden in der Ausnehmung und stehen mit dem Bauraum 11 für den Transponder in Verbindung. Hierdurch wird der Transponder 5 zusätzlich gekühlt.

Zwischen der Abdeckung und der Platte 2b befindet sich ein weiterer Freiraum 6d, durch den wiederum Luft strömen kann. Der Transponder 5 wird somit auch an seiner Innen- bzw. Unterseite gekühlt.

## Patentansprüche

1. Halterung für einen Speicherchip (5) zur Montage an einem Schmelztiegel, wobei die Halterung wenigstens einen durchgehenden Kanal (6) aufweist, durch den Luft strömen kann, um den Speicherchip (5) zu kühlen, **dadurch gekennzeichnet dass** eine Abdeckung (4) mit einem Bauraum (11) für den Speicherchip (5) vorgesehen ist, die den Speicherchip (5) nach außen hin schützt und die wenigstens einen durchgehenden Kühlkanal (10) umfasst, der im Bauraum (11) mündet.

2. Halterung nach Anspruch 1, **dadurch gekennzeichnet, dass** sie ein innen liegendes, erstes Element (1) umfasst, das im Abstand zur heißen Oberfläche des Schmelztiegels angeordnet ist ein Profil hat, das einen Kanal frei lässt.

3. Halterung nach Anspruch 2, **dadurch gekennzeichnet, dass** das erste Element (1) ein metallisches Element ist.

4. Halterung nach Anspruch 2 oder 3, **dadurch gekennzeichnet, dass** das erste Element (1) ein plattenförmiges Element ist.

5. Halterung nach einem der Ansprüche 3 oder 4, **dadurch gekennzeichnet, dass** auf dem ersten Element (1) wenigstens ein weiteres Element (2a,2b) im Abstand angeordnet ist.

6. Halterung nach Anspruch 5, **dadurch gekennzeichnet, dass** das bzw. die weiteren Elemente (2a,2b) aus Kunststoff hergestellt sind.

7. Halterung nach Anspruch 5 oder 6, **dadurch gekennzeichnet, dass** das bzw. die weiteren Elemente (2a,2b) plattenförmig sind.

8. Halterung nach einem der vorhergehenden Ansprüche, **dadurch gekennzeichnet, dass** die weiteren Elemente (2a,2b) und/oder die Abdeckung (4) aus PVDF hergestellt sind.

9. Halterung nach einem der vorhergehenden Ansprüche, **dadurch gekennzeichnet, dass** eines der Elemente (1,2a,2b) Kühlkanäle aufweist.

10. Halterung nach einem der vorhergehenden Ansprüche, **dadurch gekennzeichnet, dass** das erste Element (1) Mittel zur Montage an der Wand eines Schmelztiegels aufweist.

## Claims

1. A carrier for a memory chip (5) to be mounted on a crucible, wherein the carrier comprises at least one continuous channel (6), which can be passed through by air in order to cool the memory chip (5), **characterized in that** there is provided a cover (4) with a construction space (11) for the memory chip (5), which protects the memory chip (5) to the outside and comprises at least one cooling channel (10), which opens into the construction space (11).

2. A carrier according to claim 1, **characterized in that** it comprises an inner first element (1), which is arranged at a distance to the hot surface of the crucible and has a profile which defines a channel.

3. A carrier according to claim 2, **characterized in that** the first element (1) is a metallic element.

4. A carrier according to claim 2 or 3, **characterized in that** the first element (1) is a plate-shaped element.

5. A carrier according to claim 3 or 4, **characterized in that** at least one additional element (2a, 2b) is placed on the first element (1) at a distance.

6. A carrier according to claim 5, **characterized in that** the additional element or elements (2a, 2b), respectively, are made of a synthetic material.

7. A carrier according to claim 5 or 6, **characterized in that** the additional element or elements (2a, 2b), respectively, are plate-shaped.

8. A carrier according to any one of the preceding claims, **characterized in that** the additional elements (2a, 2b) and/or the cover (4) are made of PVDF.

9. A carrier according to any one of the preceding claims, **characterized in that** one of the elements (1, 2a, 2b) comprises cooling channels.

10. A carrier according to any one of the preceding claims, **characterized in that** the first element (1) comprises means for mounting on the wall of a crucible.

## Revendications

1. Embase pour une puce mémoire (5) en vue d'un montage sur un creuset de fusion, dans laquelle l'embase présente au moins un canal (6) de bout en bout, à travers lequel de l'air peut s'écouler, afin de refroidir la puce mémoire (5), **caractérisée en ce que** un couvercle (4) comportant un espace de montage (11) pour la puce mémoire (5) est prévu, lequel protège la puce mémoire (5) par rapport à l'extérieur et comprend au moins un canal de refroidissement (10) de bout en bout, qui débouche dans l'espace de montage (11).

2. Embase selon la revendication 1, **caractérisée en ce que** elle comprend un premier élément (1) situé à l'intérieur, qui est disposé en espacement par rapport à la surface chaude du creuset de fusion et a un profil, qui laisse à découvert un canal.

3. Embase selon la revendication 2, **caractérisée en ce que** le premier élément (1) est un élément métallique.

4. Embase selon les revendications 2 ou 3, **caractérisée en ce que** le premier élément (1) est un élément en forme de plaque.

5. Embase selon une des revendications 3 ou 4, **caractérisée en ce que** au moins un élément supplémentaire (2a, 2b) est disposé sur le premier élément (1) en espacement.

6. Embase selon la revendication 5, **caractérisée en ce que** le, respectivement les éléments supplémentaires (2a, 2b) sont fabriqués en plastique.

7. Embase selon les revendications 5 ou 6, **caractérisée en ce que** la, respectivement les éléments supplémentaires (2a, 2b) sont en forme de base.

8. Embase selon une des revendications précédentes, **caractérisée en ce que** les éléments supplémentaires (2a, 2b) et/ou le couvercle (4) sont fabriqués en PVDF.

9. Embase selon une des revendications précédentes, **caractérisée en ce que** un des éléments (1, 2a, 2b) présente des canaux de refroidissement.

10. Embase selon une des revendications précédentes, **caractérisée en ce que** le premier élément (1) présente des moyens de montage sur la paroi d'un creuset de fusion.
